(19) Europäisches Patentamt
European Patent Office
Office européen des brevets

(11) **EP 4 664 761 A1**

(12) **EUROPEAN PATENT APPLICATION**

(43) Date of publication:
**17.12.2025 Bulletin 2025/51**

(21) Application number: **24181627.1**

(22) Date of filing: **12.06.2024**

(51) International Patent Classification (IPC):
*H03K 17/16* (2006.01)    *H02M 1/08* (2006.01)
*H03K 17/567* (2006.01)    *H03K 17/0412* (2006.01)

(52) Cooperative Patent Classification (CPC):
**H03K 17/168; H02M 1/08; H03K 17/04123;**
**H03K 17/567;** H03K 2217/0036; H03K 2217/009

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **Sjöroos, Jukka-Pekka**
**Cupertino, CA 95014 (US)**
• **Tikkanen, Kari**
**New Berlin, WI 53146 (US)**

(74) Representative: **Kolster Oy Ab**
**Salmisaarenaukio 1**
**P.O. Box 204**
**00181 Helsinki (FI)**

(54) **RESONANT MODE GATE DRIVER AND CONTROL APPARATUS**

(57)     A resonant mode gate driver comprises a first, a second, and third driver arm connected in parallel between DC rails 41, 42) coupled to a unipolar DC voltage supply (43). Each driver arm includes two series connected semiconductor devices with a midpoint connection (A, B, C). A resonant inductor (L) is coupled between the midpoint connections (A, C) of the first (T1, T2) and third (T5, T6) driver arms. The second (T3, T4) and third (T5, T6) driver arms are connected in a full bridge configuration so that the midpoint connection (B) of the second driver arm (T3, T4) is coupled to a main terminal (E) of a main semiconductor switching device (M1), and the midpoint connection (C) of the third driver arm (T5, T6) is coupled to a gate (G) of the main semiconductor switching device (M1). The full-bridge circuit is configured to create a bipolar gate voltage (Vge) so that the gate voltage is of first polarity when the main semiconductor switching device (M1) is in on-state, and the gate voltage is of opposite polarity when the main semiconductor switching device is in off-state.

Fig. 4

## Description

### FIELD OF THE INVENTION

The invention relates to gate drivers, and more particularly to resonant mode gate drivers for semiconductor power switches.

### BACKGROUND OF THE INVENTION

The effort to obtain ever increasing power density of DC-DC and DC-AC converters has been limited by the size of passive components and heat sinks due to high switching losses in power semiconductors at high-frequency operation. Using resonant mode soft switching techniques and new developed Wide Band Gap (WBG) semiconductors having low switching energy, such as SiC (Silicon Carbide) MOSFET, has made high switching frequency operation possible. High switching frequency is also a requirement in high-speed motor drives and test bench applications. In these applications even IGBTs are used in hard switching mode with de-rated current.

Higher switching frequency means a higher gate drive power requirement from the power supply and a higher gate resistor power dissipation, which increases power supply size, gate driver size and decreases overall efficiency and reliability of the gate driver.

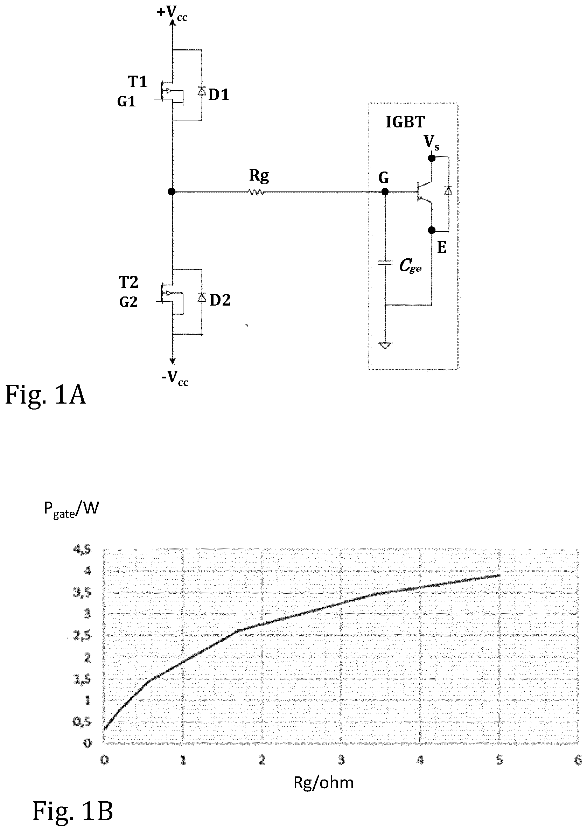

In the most common IGBT gate control technology, the gate voltage of the IGBT is controlled by a resistor and a bipolar ($\pm$Vcc) voltage source. In this method all capacitive energy is dissipated in the gate resistor which increases gate driver dimension and requires additional cooling. An example of an IGBT gate control using a bipolar voltage source ($\pm$Vcc) and a gate resistor Rg is illustrated in Fig. 1A. The gate G of the IGBT is controlled by a gate driver including a pair of output switches (MOSFETSs) T1 and T2. The switches T1 and T2 are alternately turned on and off according to respective control or gating signals G1 and G2. The IGBT turn on and off speeds du/dt and di/dt (and thereby rise and fall times) are determined by the gate resistor Rg and voltage source values Vcc. In Fig. 1A, during a turn on procedure of the IGBT, the switch T2 is first turned off and, after a required dead time, the switch T1 is turned on. The gate capacitance $G_{ge}$ (or generally the input capacitance) of the IGBT is charged from +Vcc via the switch T1 and the gate resistor Rg. During a turn off procedure of the IGBT, the switch T1 is first turned off and, after a required dead time, the switch T2 is turned on. The gate capacitance $G_{ge}$ is discharged to -Vcc via the gate resistor Rg and the switch T2.

Charging and discharging currents flow via gate resistor Rg where it is dissipated in heat. The gating loss power $P_{gate}$ dissipated in the gate resistor Rg may be determined as

$$P_{gate} = Q_{gate} * V_{gate} * fs = V_{gate}^2 * G_{ge} * fs$$

, where $Q_{gate}$ is the gate charge, fs is switching frequency, $V_{gate}$

is the gate voltage, which equals to the electric potential difference between the gate-on voltage and the gate-off voltage (e.g, $V_{gate}$ = +Vcc -(-Vcc), +Vcc being the positive power supply and -Vcc being the negative power supply. Thus, the gating loss is proportional to the switching frequency and related to the gate charge or input capacitance of the IGBT. Especially in the high frequency soft-switching converter applications, the transistor gating loss can have significant impact on the power conversion efficiency. A more significant advantage is that there is not need to transfer power losses out of the device. This allows increasing the packaging density and reducing the size of the device. Alternatively, it allows decreasing the temperature of the components and increase their reliability and lifetime. For example, with a large power module having $Q_{gate}$ =16.8 $\mu$C per IGBT and having $\pm$15 V power supply, the calculated gating loss at fs=10 kHz would be $P_{gate}$=16.8 $\mu$C * 30 V * 10 kHz = 5 W. In a three-phase inverter module with six IGBTs, the total gate driver power dissipation would be 30 W. This power may be supplied through two power supplies, namely the gate power supply $\pm$Vcc and a main power supply Vs which takes power from a DC bus of the inverter. Assuming a typical 80% efficiency per power supply, the total input power taken would be $P_{in}$= 30 W/0.8/0.8 = 47 W. Higher gate power loss increases the size of gate resistors where power is dissipated and requires bulkier power supplies. Fig. 1B shows an example of the gating loss power $P_{gate}$ in function of the value of the gate resistor Rg.

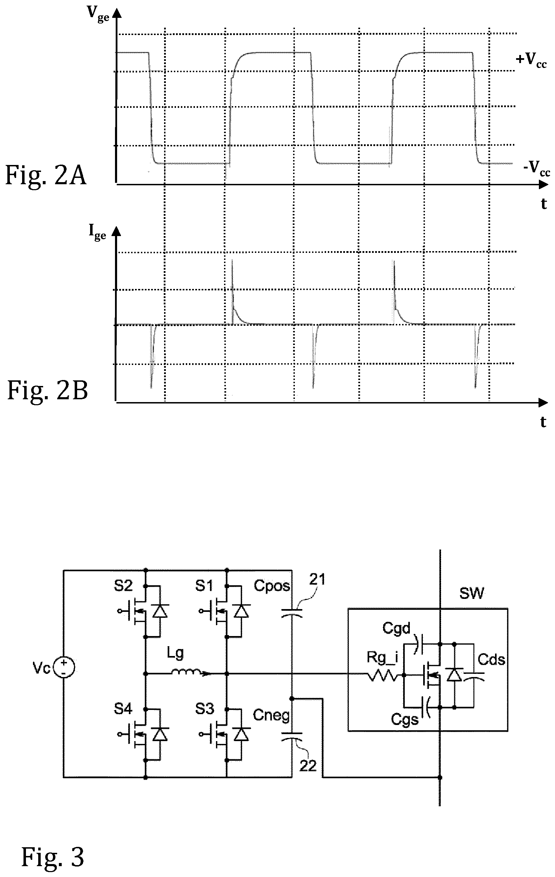

Switching speed is not programmable, but the gate resistor would have to be changed to change the switching speed. Figs. 2A and 2B show simulated gate voltage $V_{ge}$ and gate current $I_{ge}$ for the above defined IGBT power module. Duration of the of the gating transient is dominantly defined by the time constant of the gate resistor Rg and the IGBT input capacitance. A faster gating transient can be achieved by a smaller gate resistor, which helps to reduce the switching loss of the IGBT..

A resonant mode gate driver has been proposed to achieve lower gating loss. The basic idea of the resonant mode gate driver is to compose a current source to drive the main switch. Therefore, the resonant mode gate driver is also referred as the current source gate driver. The power loss of the resonant mode gate driver is composed by the loss on the transistor gate resistor, an ancillary transistor/diode bridge and a resonant tank. Fig. 3 shows a resonant mode gate driver disclosed in US 8847631 B2. A resonant inductor Lg is installed between the mid points of a full bridge formed by four transistors S1-S4. The four transistors are modulated to provide states for an inductor current forming, a gate charge/discharge and a power recovery. Excessive energy is stored in the inductor and returned to the gate voltage source VG. In a turn-on stage of the power switch SW, transistor S1 is turned on and the gate of SW is clamped to voltage +Vc. The turn-off procedure begins with the turn-on of S4. With the turn-on of S4, a current is established through the inductor Lg that increases linearly with time until the magnitude reaches a preset value such that S1 is turned-off. With the turn-off of S1, the energy stored in the Lg (together with the voltage on a capacitor Cneg 22) discharges the gate capacitor Cm. The antiparallel diode of S3 is forced on when the gate voltage reaches the voltage on the capacitor Cneg 22. S3 is turned-on and the procedure ends with the turn-off of S4 causing a recovery of the energy stored in the inductor Lg back to the power supply Vc. The inductor current reduces linearly until it reaches zero. The gate of SW is clamped to voltage -Vc. The gate driver circuit remains in this turn-off state until a control signal instructs the turn-on procedure. S2 is turned on establishing a current through Lg. With the turn-off of S3, the energy stored in Lg (together with the voltage on a capacitor Cpos 21) operate to charge the gate input Cm so that the power switch is turned on. The antiparallel diode of S1 is turned on when the gate voltage reaches Vcpos, freewheeling the inductor current. This procedure ends when S2 is turned off, recycling inductor energy back to the gate power supply Vc. When the inductor current drops to zero, the antiparallel diode of S4 is turned off.

BRIEF DESCRIPTION OF THE INVENTION

An object of the present invention is to provide a new resonant mode gate driver allowing a simpler power source and optionally an active control of rise/fall times of a gate voltage. The objects of the invention are achieved by a resonant mode gate driver and a control apparatus recited in the independent claims. Embodiments of the invention are disclosed in the dependent claims.

A first aspect of the invention is a resonant mode gate driver comprising:

a first DC rail and second DC rail configured be coupled to a unipolar DC voltage supply having a DC voltage Vcc;
a first driver arm coupled between the first DC rail and the second DC rail and including a first semiconductor device and second semiconductor device coupled at a first midpoint connection;
a resonant inductor, and
a full-bridge circuit having
a second driver arm coupled between the first DC rail and the second DC rail and including a third semiconductor device and a fourth semiconductor device coupled at a second midpoint connection, and
a third driver arm coupled between the first DC rail and the second DC rail and including a fourth semiconductor device and a fifth semiconductor device coupled at a third midpoint connection,
wherein the second midpoint connection of the full-bridge circuit is configured to be coupled to a main terminal of a mains witching device, and wherein the third midpoint connection of the full-bridge circuit is configured to be coupled to a gate of the main semiconductor switch, the gate having a gate capacitance,
wherein the full-bridge circuit is configured to create a bipolar gate voltage at the third midpoint connection, the gate voltage being of first polarity when the main semiconductor switch is in on-state and the gate voltage being of opposite polarity when the main semiconductor switch is in off-state, and
wherein the resonant inductor is coupled between the first midpoint connection and the third midpoint connection.

In an embodiment, the resonant inductor, the first semiconductor device, the second semiconductor device, the third semiconductor device, and the fourth semiconductor device are configured to transmit power between the third midpoint connection and the gate of the main semiconductor switch for turning the main semiconductor switch on and off.

In an embodiment, in the on-state of the main semiconductor switch, the fourth and fifth semiconductor devices are in on-state, the third and sixth semiconductor devices are in off-state, and the gate voltage is at +Vcc, and wherein in the off-state of the main semiconductor switch, the third and sixth semiconductor devices are in on-state, the fourth and fifth semiconductor devices are in off-state, and the gate voltage is at -Vcc.

In an embodiment, the resonant mode gate driver is configured to turn on the main semi-conductor switch with a turn-on procedure including

closing the first semiconductor device and opening the sixth semi-conductor device to discharge the gate capacitance through the resonant induc-tor,
opening, in response to the gate voltage reaching zero voltage, the third semiconductor device and closing the fourth semiconductor device to charge the gate capacitance through the resonant inductor,
opening, in response to the gate voltage reaching +Vcc, the first semi-conductor device and closing the fifth semiconductor device to return stored energy from the resonant inductor to the unipolar DC voltage supply.

In an embodiment, the resonant mode gate driver is configured to turn off the main semi-conductor switch with a turn-off procedure including

closing the second semiconductor device and opening the fifth semi-conductor device to discharge the gate capacitance,
opening, in response to the gate voltage reaching zero voltage, the fourth semiconductor device and closing the third semiconductor device to charge the gate capacitance through the resonant inductor,
opening, in response to the gate voltage reaching -Vcc, the second semiconductor device and closing the sixth semiconductor device to return stored energy from the resonant inductor to the unipolar DC voltage supply.

In an embodiment, wherein the resonant mode gate driver comprises an active gate control in form of a high-frequency pulse width modulation of the gate current of the main semiconductor switch during turn-on and turn-off of the main semiconductor switch.

In an embodiment, the pulse width modulation of the gate current is performed for at least portion of the time the gate capacitance is charged during turn-on and turn-off of the main semiconductor switch.

In an embodiment, wherein the switching speed, di/dt and du/dt, of an output current and/or an output voltage of the main semiconductor switch during turn-on and turn-off of the main semiconductor switch are dependent on a frequency and/or a duty cycle of the high-frequency pulse width modulation.

In an embodiment, the pulse width modulation of the gate current comprises a high-frequency pulse width modulation of a gating signal applied to the fourth semi-conductor device at the beginning and at the end of a turn-on pulse of the gating signal.

In an embodiment, the rise time of the gate voltage during turn-on of the main semiconductor switch as well as the fall time of the gate voltage during turn-off of the main semiconductor switch are dependent on a frequency and/or a duty cycle of the high-frequency pulse width modulation.

In an embodiment, the pulse width modulation of the gate current comprises a high-frequency pulse width modulation of a gating signal applied to the fourth semi-conductor device at the beginning and at the end of a turn-on pulse of the gating signal.

A second aspect of the invention is a switching apparatus, comprising

> one or more main semiconductor switches,
> one or more resonant mode gate drivers according to the first aspect connected to drive the main semiconductor switches, and
> a controller configured to operate one or more resonant mode gate drivers by providing gating signals to the semiconductor devices of the one or more resonant mode gate drivers so as to form a bipolar gate voltage to each of the one or more main semiconductor switches.

In an embodiment, the con-troller is configured to provide an active gate control by controlling the one or more resonant mode gate drivers to high-frequency pulse width modulate of the gate current of the one or more main semi-conductor switches during turn-on and turn-off of the main semi-conductor switch.

In an embodiment, the con-troller is configured to control the rise time of the gate voltage during turn-on of the main semiconductor switch as well as the fall time of the gate voltage during turn-off of the main semiconductor switch by adjusting a frequency and/or a duty cycle of the high-frequency pulse width modulation.

In an embodiment, the controller comprises one or more processors, and one or more memories including computer program code, which, when loaded into the one or more processors and executed by the one or more processors, causes the controller to operate the one or more resonant mode gate drivers.

BRIEF DESCRIPTION OF THE DRAWINGS

In the following the invention will be described in greater detail by means of exemplary embodiments with reference to the accompanying drawings, in which

> Figure 1A shows an example of a conventional IGBT gate control using a bipolar voltage source ($\pm$Vcc) and a gate resistor Rg;
> Fig. 1B shows an example of the gating loss power $P_{gate}$ in function of the value of the gate resistor Rg;
> Figure 2A and 2B show simulated gate voltage $V_{ge}$ and gate current $I_{ge}$ for an IGBT power module;
> Figure 3 shows a prior art resonant mode gate driver;
> Figure 4 shows an exemplary circuit diagram of a resonant mode gate driver concept according to embodiments of the invention;
> Figure 5 shows an exemplary timing diagram of a gate control with unipolar power supply voltage according to an embodiment of the invention;
> Figures 6A, 6B, 6C, 6D, 6E, 6F and 6G illustrate current paths in different states of the gate control in the resonant mode gate driver of Fig. 4;
> Figures 7A, 7B, 7C and 7D show exemplary waveforms of an active gate controlling according to an embodiment; and
> Figure 8 illustrates exemplary behaviour of the gate voltage $V_{ge}$ with different duty cycles from 100% to 10%.

DETAILED DESCRIPTION

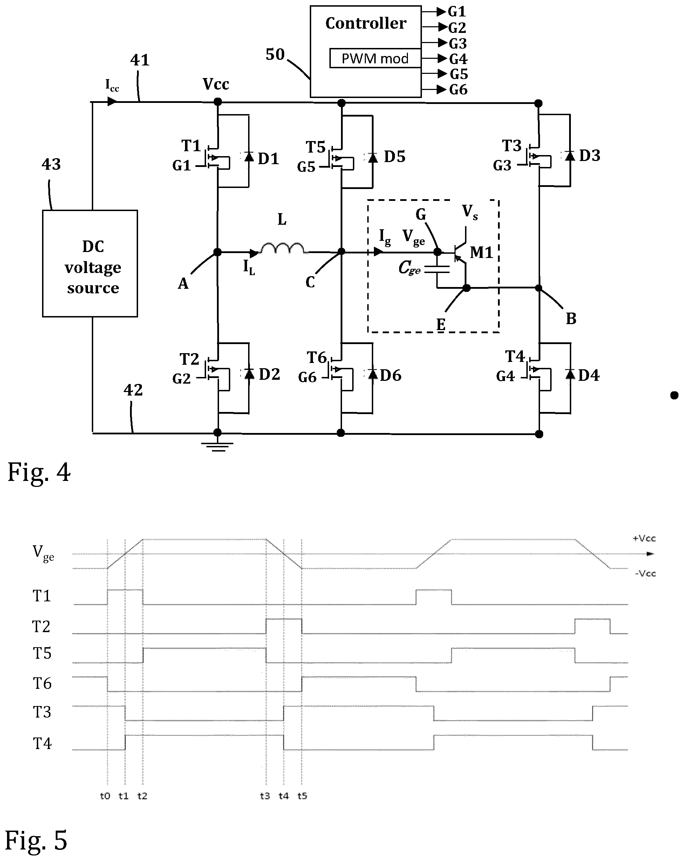

Figure 4 shows an exemplary circuit diagram of a resonant mode gate driver concept according to embodiments of the invention. The gate driver is designed to be coupled to drive a main semiconductor power switching element M1. The main semiconductor switch M1 may be an insulated-gate bipolar transistor (IGBT), or another type of semiconductor switching device, such as an integrated gate-commutated thyristor (IGCT), a metal-oxide-semiconductor field-effect transistor (MOSFET), or a silicon carbide (SiC) MOSFET to name several examples.

The gate driver includes a first DC rail 41 and second DC rail 42 coupled to a unipolar DC voltage supply 43 having a DC voltage Vcc. A first upper semi-conductor device T1 and second lower semiconductor device T2 (a first driver arm) with antiparallel diodes D1 and D2 are connected in series between the first DC rail 41 and the second DC rail 42. The drain or collector of the first upper semiconductor device T1 is connected to the first DC rail 41 and the source or emitter of T1 is connected to a first midpoint connection. The drain or collector of the second lower semiconductor device T2 is connected to the first midpoint connection A and the source or emitter of T2 is connected to the second DC rail 42.

A third upper semiconductor device T3 and a fourth lower semiconductor device T4 (a second driver arm) with antiparallel diodes D3 and D4 are connected in series between the first DC rail 41 and the second DC rail 42. The drain or collector of the third upper semiconductor device T3 is connected to the first DC rail 41 and the source or emitter of T2 is connected to a second midpoint connection B. The drain or collector of the fourth lower semiconductor device T4 is connected to the second midpoint connection B and the source or emitter of T4 is connected to the second DC rail 42.

A fifth upper semiconductor device T5 and a sixth lower semiconductor device T6 (a third driver arm) with antiparallel diodes D5 and D6 are connected in series between the first DC rail 41 and the second DC rail 42. The drain or collector of the fifth upper semiconductor device T5 is connected to the first DC rail 41 and the source or emitter of T5 is connected to a third midpoint connection C. The drain or collector of the sixth lower semiconductor device T6 is connected to the third midpoint connection C and the source or emitter of T6 is connected to the second DC rail 42.

The second driver arm T3, T4 and the third driver arm T5, T6 may be arranged in a full-bridge or H-bridge topology. A bipolar gate voltage Vge (e.g., ±Vcc) is provided from the unipolar DC voltage Vcc by controlling the switching of the full bridge. The main semiconductor switch M1, which is driven by the gate driven, can be coupled between the midpoint connections C and B of the full bridge. More specifically, the second midpoint connection B of the full bridge is configured to be coupled to an emitter or source terminal E of the main semiconductor switch M1, while the third midpoint connection C of the full bridge is configured to be coupled to a gate terminal G of the main semiconductor switch M1. The gate of M1 may exhibit a gate capacitance Cge relative to the emitter or source E. A bipolar gate voltage Vge (e.g., ±Vcc) is provided from the unipolar DC voltage Vcc by using the full-bridge T3, T4, T5, and T6 with an alternate switch control.

A resonator inductor L may be coupled between the first midpoint connection A of the first driver arm and the third midpoint connection C of the third driver arm. The resonator inductor L provides a current source to drive the main semiconductor switch M1. The gate energy of M1 is recycled back to the power supply 43 using the inductor L as a temporary energy storage. Energy recycling dramatically improves gate driver efficiency, reduces power supply size, reduces gate driver size and cost, eliminates need for a cooling fan and enhances reliability. In the example above, the gate power consumption of a conventional gate driver was 5 W, when the gate charge $Q_{gate}$ was 16.8 μC, the switching frequency was 10 kHz, the gate resistance Rg was 0,56 ohm, and the gate voltage was ±15 V. With the same parameters, the gate power loss $P_h$ of the resonant mode gate driver according to an embodiment the invention is 1, 425 W, for example. The total reduction of the power loss would be 71 %.

The semiconductor devices T1, T2, T3, T4, T5 and T6 are controlled by control or gating signals G1, G2, G3, G4, G5 and G6, respectively. The control signals may be provided by any suitable control unit or control system, referred as a controller 50 herein, which is configured to control the switching operation of one or more the gate drivers, and which may optionally be configured to control overall operation of a DC-DC or DC-AC converter or a motor drive, wherein the gate driver or gate drivers are employed. The controller 50 is configured to open and close (turn on and turn off) the main semiconductor switch M1 by operating the semi-conductor devices T1-T6 to transmit power between the third midpoint connection C and the gate G of the main semiconductor switch M1. In an embodiment, the controller comprises Field Programmable Gate Arrays (FPGA).

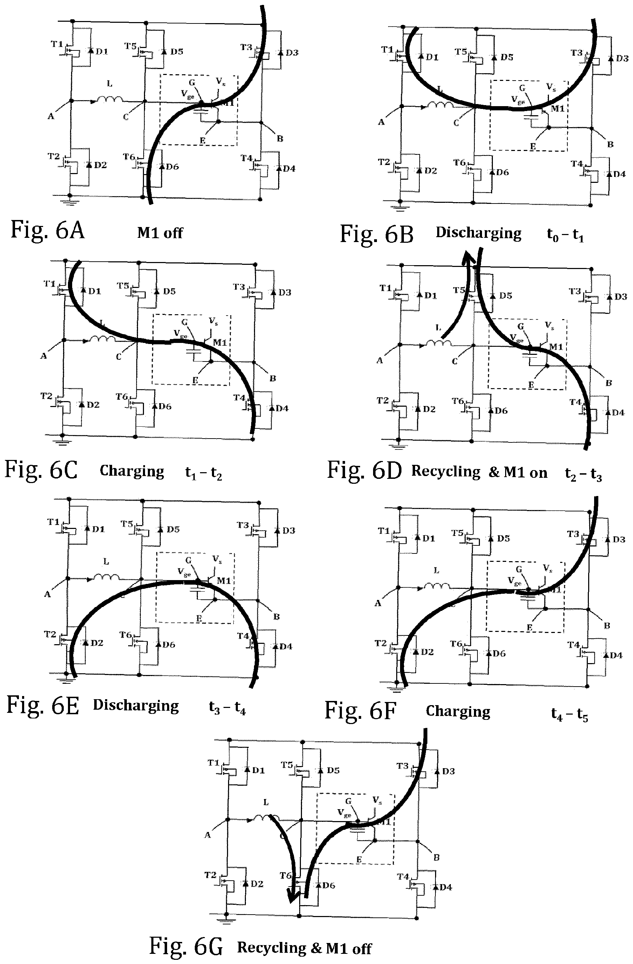

Fig. 5 shows an exemplary timing diagram of a gate control with unipolar power supply voltage according to an embodiment of the invention. Operational waveforms of the gate voltage Vge of M1 and control signals G1-G6 of the semiconductor devices T1-T6 are shown. Figs. 6A-6G illustrate current paths in different states of the gate control. A bipolar gate voltage Vge (e.g., ±Vcc) is provided from the unipolar DC voltage Vcc by controlling the switching of the full bridge formed by the semiconductor devices T3-T6. In the on-state of M1 (e.g., Fig. 6D), T4 and T5 are in on-state, T3 and T6 are in off-state, and the gate voltage Vge is at +Vcc. In the off-state of M1 (e.g., Figs. 6A and 6G), T3 and T6 are in on-state, T4 and T5 are in off-state, and the gate voltage Vge is at -Vcc. At time instant $t=t_0$, the turn-on procedure of M1 is started by turning T1 on and T6 off. The input capacitance Cge of M1 will begin discharging through T1, the resonant inductor L and T3 (Fig. 6B). At time instant $t=t_1$, the gate voltage Vge reaches zero. The controller 50 may detect the zero gate voltage Vge by means of a zero voltage detector, such as a Schmitt trigger or like, which monitors the potential at the gate G. When the Vge is zero, T3 is turned off and T4 is turned on. During the time $t_1$-$t_2$, the gate voltage Vge is charged through T1, L and T4 to the potential +Vcc (Fig. 6C). At time instant $t_2$, when the gate voltage Vge reaches +Vcc, T1 is turned off and T5 is turned on. At the same time the energy (the gate energy) stored in the resonant inductor L is returned to the DC voltage source through T5 and D2 (Fig. 6D). During the time $t_2$-$t_3$, in the on-state of M1, T5 and T4 are in on-state and the gate voltage Vge = +Vcc (Fig. 6D).

At time instant $t=t_3$, the turn-off procedure of M1 is started by turning T2 on and T5 off. The input capacitance Cge will begin discharging through T4, the inductor Land T2 (Fig. 6E). At time instant t=$t_4$, the gate voltage Vge reaches zero, T4 is turned off and T3 is turned on. During time $t_4$-$t_5$, the gate voltage Vge is charged through T3, L and T2 to the potential -Vcc (Fig. 6F). At time instant $t_5$, when the gate voltage Vge reaches -Vcc, T2 is turned off and T6 is turned on. At the same time energy stored to the inductor (the gate energy) is returned to the DC voltage source through T6 and D1 (Fig. 6G). After time instant t5, in the off-state of M1, T3 and T6 are on and Vge=-Vcc until next turn-on procedure begins.

Embodiments of the invention provide a new resonant mode gate driver control method that results in nearly lossless gate driver. Due to the full bridge configuration need of bipolar power supply (i.e., the negative power supply) is eliminated. Unipolar power supply simplifies and reduces cost of the gate driver power supply.

According to an aspect of the invention, a resonant mode gate driver control comprises an active gate control achieved by high-frequency pulse width modulation (PWM) of the gate current of the main semiconductor switch during turn-on and turn-off of the main semiconductor switch. The modulated gate current is supplied by the resonant inductor operating as a current source. With the active gate control, the rate of the gate current change over time, di/dt, and the rate of the gate voltage change over time, du/dt, can be controlled or programmed. In other words, the rise time of the gate voltage $V_{ge}$ during turn-on of the main semi-conductor switch as well as the fall time of the gate voltage $V_{ge}$ during turn-off of the main semiconductor switch can be controlled. Thereby also the switching speed, di/dt and du/dt, of output current and output voltage of the main semiconductor switch can be controlled or programmed. The capability to control du/dt and di/dt of the main semiconductor switch, e.g., IGBT, enables the reduction of motor bearing currents in motor drive applications, reduces power cycling and electromagnetic interference (EMI), and increases life and reliability of semiconductor switching devices. In embodiments, the PWM modulation frequency may be 1 MHz or more, preferably 5 MHz or more. The switching frequency fs is one order or several orders lower than the PWM modulation frequency. The switching frequency fs for IGBT device may be from 2 kHz to 20 kHz, for example. The frequencies of the gating signals G1-G6 are same order as the switching frequency fs.

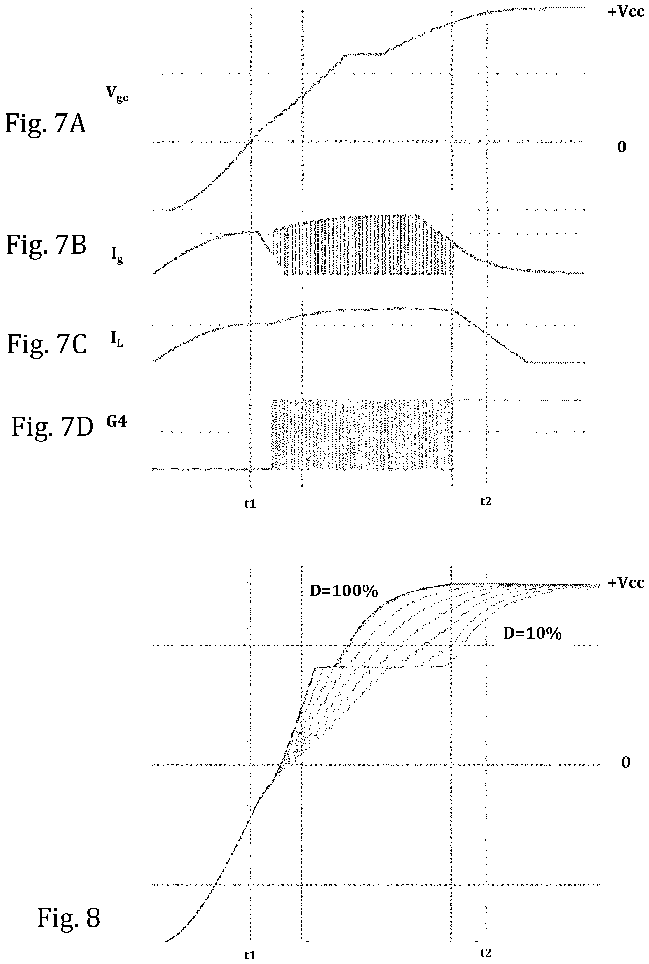

In an embodiment, the modulation of the gate current comprises a high-frequency PWM modulation of the lower-frequency gating signal G4 applied to the gate of the fourth lower semiconductor device T4 with a high-frequency PWM signal at the beginning and at the end of a G4 turn-on pulse applied to the gate of T4. Exemplary waveforms of an active gate controlling according to an embodiment are illustrated in Figs. 7A-7D. The time instants t1 and t2 may correspond to the time instants t1 and t2 in Figs. 5 and 6A-6G. During the period t1-t2 the resonant inductor L provides a current source charging the gate capacitor $C_{ge}$ of M 1. When T4 is turned off the potential at the emitter E is floated and the potential at the gate G is clamped to the Vcc. During the off-time of T4 the inductor current $I_L$ is clamped through T1 and D5 and remains unchanged. When T4 is turned on the inductor current $I_L$ charges the gate capacitance $C_{ge}$. As the gating signal G4 is modulated by the high frequency PWM, T4 is turned on and off accordingly at the high frequency. Thereby the gate current $I_{ge}$ is turned on and off accordingly at the high frequency. The gate capacitance $C_{ge}$ is charged only during on-time of the gate current $I_{ge}$ so that the charging time of the gate capacitance $C_{ge}$ will be longer compared to an unmodulated gate current. Similarly, the rise time of the gate voltage $V_{ge}$ (from zero to +Vcc) is prolonged. The rise time or du/dt of the gate voltage $V_{ge}$ can be controlled by changing the duty cycle (on-time/off-time) or frequency of the PWM modulation. Fig. 8 illustrates exemplary behaviour of the gate voltage $V_{ge}$ with modulation frequency of 10 MHz and with different duty cycles from 100% to 10%. The switching frequency fs was 10 kHz. Similarly, the fall time or du/dt of the gate voltage $V_{ge}$ can be controlled by a high frequency PWM modulation of the gating signal G4 applied to the gate of the fourth lower semiconductor device T4 during the period t4-t5 at the end of the G4 turn-on pulse. The PWM modulation of the gating signal G4 may be implemented in the controller 50, for example.

The gate driver control, such as the controller 50, controlling the resonant mode gate driver in accordance embodiments of the invention may be implemented by various means. For example, these techniques may be implemented in hardware (one or more devices), firmware (one or more devices), software (one or more modules), or combinations thereof. For a firmware or software, implementation can be through modules (e.g., procedures, functions, and so on) that perform the functions described herein. The software codes may be stored in any suitable, processor/computer-readable data storage medium(s) or memory unit(s) and executed by one or more processors/computers. The data storage medium or the memory unit may be implemented within the processor/computer or external to the processor/computer, in which case it can be communicatively coupled to the processor/computer via various means as is known in the art.

The description and the related drawings are only intended to illustrate the principles of the present invention by means of examples. Various alter-native embodiments, variations and changes are obvious to a person skilled in the art on the basis of this description. The present invention is not intended to be limited to the examples described herein but the invention may vary within the scope and spirit of the appended claims.

## Claims

1. A resonant mode gate driver comprising:

a first DC rail and second DC rail configured be coupled to a unipolar DC voltage supply having a DC voltage Vcc;

a first driver arm coupled between the first DC rail and the second DC rail and including a first semiconductor device and second semiconductor device coupled at a first midpoint connection;

a resonant inductor, and

a full-bridge circuit having

a second driver arm coupled between the first DC rail and the second DC rail and including a third semiconductor device and a fourth semiconductor device coupled at a second midpoint connection, and

a third driver arm coupled between the first DC rail and the second DC rail and including a fourth semiconductor device and a fifth semiconductor device coupled at a third midpoint connection, wherein the second midpoint connection of the full-bridge circuit is configured to be coupled to a main terminal of a main semiconductor switching device, and wherein the third midpoint connection of the full-bridge circuit is configured to be coupled to a gate of the main semiconductor switching device, the gate having a gate capacitance,

wherein the full-bridge circuit is configured to create a bipolar gate voltage at the third midpoint connection, the gate voltage being of first polarity when the main semiconductor switching device is in on-state and the gate voltage being of opposite polarity when the main semiconductor switching device is in off-state, and

wherein the resonant inductor is coupled between the first midpoint connection and the third midpoint connection.

2. The resonant mode gate driver as claimed in claim 1, wherein the resonant inductor, the first semiconductor device, the second semiconductor device, the third semiconductor device, and the fourth semiconductor device are configured to transmit power between the third midpoint connection and the gate of the main semiconductor switch for turning the main semiconductor switching device on and off.

3. The resonant mode gate driver as claimed in claim 1 or 2, wherein in the on-state of the main semiconductor switch, the fourth and fifth semiconductor devices are in on-state, the third and sixth semiconductor devices are in off-state, and the gate voltage is at +Vcc, and wherein in the off-state of the main semiconductor switching device, the third and sixth semiconductor devices are in on-state, the fourth and fifth semiconductor devices are in off-state, and the gate voltage is at -Vcc.

4. The resonant mode gate driver as claimed in any one of claims 1-3, wherein the resonant mode gate driver is configured to turn on the main semiconductor switching device with a turn-on procedure including

closing the first semiconductor device and opening the sixth semiconductor device to discharge the gate capacitance through the resonant inductor,

opening, in response to the gate voltage reaching zero voltage, the third semiconductor device and closing the fourth semiconductor device to charge the gate capacitance through the resonant inductor,

opening, in response to the gate voltage reaching +Vcc, the first semi-conductor device and closing the fifth semiconductor device to return stored energy from the resonant inductor to the unipolar DC voltage supply.

5. The resonant mode gate driver as claimed in any one of claims 1-4, wherein the resonant mode gate driver is configured to turn off the main semiconductor switching device with a turn-off procedure including

closing the second semiconductor device and opening the fifth semiconductor device to discharge the gate capacitance,

opening, in response to the gate voltage reaching zero voltage, the fourth semiconductor device and closing the third semiconductor device to charge the gate capacitance through the resonant inductor,

opening, in response to the gate voltage reaching -Vcc, the second semiconductor device and closing the sixth semiconductor device to return stored energy from the resonant inductor to the unipolar DC voltage supply.

6. The resonant mode gate driver as claimed in any one of claims 1-5, wherein the resonant mode gate driver comprises an active gate control in form of a high-frequency pulse width modulation of the gate current of the main semiconductor switch during turn-on and turn-off of the main semiconductor switch.

7. The resonant mode gate driver as claimed in claim 6, wherein the pulse width modulation of the gate current is performed for at least portion of the time the gate capacitance is charged during turn-on and turn-off of the main semi-conductor switching device.

8. The resonant mode gate driver as claimed in claim 6 or 7, wherein the switching speed, di/dt and du/dt, of an output current and/or an output voltage of the main semiconductor switching device during turn-on and turn-off of the main semiconductor switch are dependent on a frequency and/or a duty cycle of the high-frequency pulse width modulation.

9. The resonant mode gate driver as claimed in any one of claims 6-8, wherein the pulse width modulation of the gate current comprises a high-frequency pulse width modulation of a gating signal applied to the fourth semiconductor device at the beginning and at the end of a turn-on pulse of the gating signal.

10. The resonant mode gate driver as claimed in any one of claims 6-9, wherein the rise time of the gate voltage during turn-on of the main semiconductor switch as well as the fall time of the gate voltage during turn-off of the main semi-conductor switching device are dependent on a frequency and/or a duty cycle of the high-frequency pulse width modulation.

11. The resonant mode gate driver as claimed in any one of claims 6-10, wherein the pulse width modulation of the gate current comprises a high-frequency pulse width modulation of a gating signal applied to the fourth semiconductor device at the beginning and at the end of a turn-on pulse of the gating signal.

12. A switching apparatus, comprising

    one or more main semiconductor switching devicess,
    one or more resonant mode gate drivers as claimed in any one of claims 1-11 connected to drive the main semiconductor switches, and
    a controller configured to operate one or more resonant mode gate drivers by providing gating signals to the semiconductor devices of the one or more resonant mode gate drivers so as to form a bipolar gate voltage to each of the one or more main semiconductor switching devices.

13. The switching apparatus as claimed in claim 12, wherein the con-troller is configured to provide an active gate control by controlling the one or more resonant mode gate drivers to high-frequency pulse width modulate of the gate current of the one or more main semiconductor switching devices during turn-on and turn-off of the main semiconductor switching device.

14. The switching apparatus as claimed in claim 13, wherein the con-troller is configured to control the rise time of the gate voltage during turn-on of the main semiconductor switching device as well as the fall time of the gate voltage during turn-off of the main semiconductor switching device by adjusting a frequency and/or a duty cycle of the high-frequency pulse width modulation.

15. The switching apparatus as claimed in any one of claims 12-14, wherein the controller comprises one or more processors, and one or more memories including computer program code, which, when loaded into the one or more processors and executed by the one or more processors, causes the controller to operate the one or more resonant mode gate drivers.

Fig. 1A

Fig. 1B

Fig. 2A

Fig. 2B

Fig. 3

Fig. 4

Fig. 5

Fig. 6A  M1 off

Fig. 6B  Discharging  $t_0 - t_1$

Fig. 6C  Charging  $t_1 - t_2$

Fig. 6D  Recycling & M1 on  $t_2 - t_3$

Fig. 6E  Discharging  $t_3 - t_4$

Fig. 6F  Charging  $t_4 - t_5$

Fig. 6G  Recycling & M1 off

Fig. 7A — $V_{ge}$

Fig. 7B — $I_g$

Fig. 7C — $I_L$

Fig. 7D — G4

Fig. 8

Europäisches
Patentamt
European
Patent Office
Office européen
des brevets

# EUROPEAN SEARCH REPORT

**Application Number**

EP 24 18 1627

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/162322 A1 (TAO FENGFENG [US] ET AL) 27 June 2013 (2013-06-27) * paragraphs [0027] - [0034]; figures 1-10 * | 1-15 | INV. H03K17/16 H02M1/08 H03K17/567 H03K17/0412 |
| X | US 6 441 673 B1 (ZHANG RICHARD S [US]) 27 August 2002 (2002-08-27) * column 2, line 25 - column 4, line 44; figures 1-11 * | 1-15 | |
| A | US 2018/234092 A1 (SJOROOS JUKKA-PEKKA [FI] ET AL) 16 August 2018 (2018-08-16) * the whole document * | 1-15 | |
| A | US 2012/206170 A1 (KIMURA TOMONORI [JP] ET AL) 16 August 2012 (2012-08-16) * the whole document * | 1-15 | |

**TECHNICAL FIELDS SEARCHED (IPC)**

H03K
H02M

The present search report has been drawn up for all claims

| Place of search | Date of completion of the search | Examiner |
|---|---|---|
| The Hague | 15 November 2024 | João Carlos Silva |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 18 1627

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2024

| Patent document cited in search report | Publication date | Patent family member(s) | Publication date |
|---|---|---|---|
| US 2013162322 A1 | 27-06-2013 | NONE | |
| US 6441673 B1 | 27-08-2002 | NONE | |
| US 2018234092 A1 | 16-08-2018 | NONE | |
| US 2012206170 A1 | 16-08-2012 | JP 5263316 B2 | 14-08-2013 |
| | | JP 2012169904 A | 06-09-2012 |
| | | US 2012206170 A1 | 16-08-2012 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8847631 B2